# EUROPEAN PATENT APPLICATION

(11) **EP 4 403 270 A1**
(43) Date of publication of application: **24.07.2024**
(21) Application number: 22869126.7
(22) Date of filing: 09.09.2022
(51) Int. Cl.: B08B 7/00, H05H 1/24

(54) **CLEANING METHOD FOR PLASMA ETCHING CHAMBER, AND APPLICATION THEREOF**

(30) Priority: 17.09.2021 CN 202111092346
(71) Applicant: Jiangsu Leuven Instruments Co. Ltd, Xuzhou, Jiangsu 221300 (CN)
(72) Inventor: LIANG, Feng, Xuzhou, Jiangsu 221300 (CN); YANG, Yuxin, Xuzhou, Jiangsu 221300 (CN); LI, Xuedong, Xuzhou, Jiangsu 221300 (CN); LIU, Xiaobo, Xuzhou, Jiangsu 221300 (CN); LI, Jiahe, Xuzhou, Jiangsu 221300 (CN); PENG, Taiyan, Xuzhou, Jiangsu 221300 (CN); XU, Kaidong, Xuzhou, Jiangsu 221300 (CN)
(74) Representative: Eisenführ Speiser
(86) International application number: PCT/CN2022/118025
(87) International publication number: WO 2023/040757

(57) **Abstract**

A cleaning method for a plasma etching chamber, comprising the following steps: A) placing a cleaning sheet (1) in a plasma etching chamber after completed sample processing, and introducing an inert gas for capacitively coupled plasma (CCP) cleaning; B) and then introducing a chemical cleaning gas for inductively coupled plasma (ICP) cleaning, the chemical cleaning gas comprising one or more of CH₂F₂, CF₄, NF₃, SF₆, and O₂. The CCP Faraday physical cleaning is performed in the plasma etching chamber, and then the ICP chemical cleaning is performed, which not only has a good cleaning effect on both a chamber wall and a window of the plasma etching chamber, but also improves the cleaning capability of multiple metal contaminations by means of different combinations of gases.

## Description

This application claims the priority of Chinese patent application No. 202111092346.5, titled with "CLEANING METHOD FOR PLASMA ETCHING CHAMBER, AND APPLICATION THEREOF", filed with the China National Intellectual Property Administration on September 17, 2021, , which is hereby incorporated by reference in its entirety.

### FIELD

The present disclosure belongs to the technical field of semiconductor technology, particularly relates to a method and its application for cleaning plasma etching chambers.

### BACKGROUND

In the process of integrated circuit manufacturing and MEMS, etching is a common processing step, which uses chemical or physical methods to etch certain pattern on a base surface. Etching is divided into dry etching and wet etching. In dry etching, reactive ion etching (RIE) is applied in many fields because of its good selectivity, high anisotropy and good etching accuracy.

Reactive ion etching (RIE) refers to the process of etching a sample surface using high-energy active substances such as ions, electrons and free radicals generated by glow discharge of etching gas using a high frequency electric field in a chamber with a certain degree of vacuum. The etching process comprises both physical and chemical effects. Physical effect refers to the process in which the ions are given high kinetic energy under an electric field and bombard the sample surface to generate sputter etching, and chemical effect refers to the process in which the high chemical active ions, electrons and free radicals react chemically with substances on sample surface.

At present, most materials etched by an etching equipment are very single, (such as Pt, Ru, Ir, NiFe, Au, etc.) so the cleaning process is also relatively single, which is only for a particular material. However, with the continuous development of the third generation memory - magnetoresistive random-access memory (MRAM) in recent years and the continuous improvement of integration level, the need for dry etching of new non-volatile materials such as metal gate material (such as Mo, Ta, etc.) and high dielectric gate material (such as Al₂O₃, HfO₂, and ZrO₂, etc.) is continuous growing. MRAM has a complicated film with many different materials, thus the mixed metal-SiO contamination will be generated in the chamber after the completion of etching, which is hard to be removed by a vacuum pump. This will not only generate particles contamination, but also lead to a decrease in the repeatability of the process over time. To solve the side wall deposition and particles contamination generated by non-volatile materials in dry etching process, it is necessary to improve the efficiency of cleaning process for plasma etching chambers.

### SUMMARY

The purpose of present disclosure is to provide a method and its application for cleaning plasma etching chambers. The method in present disclosure has excellent cleaning effect for both of the mixed metal-SiO contamination attached to wall and window of the chamber.

The present disclosure provides a method for cleaning plasma etching chambers, comprising following steps:

A) Placing cleaning sheet in a plasma etching chamber after the sample processing is completed and introducing inert gas to conduct capacitively coupled plasma cleaning;

B) Thereafter, introducing chemical cleaning gas to conduct inductively coupled plasma cleaning;

The chemical cleaning gas is one or more of CH₂F₂, BCl₃, CF₄, NF₃, SF₆, Cl₂ and O₂.

Preferably, the inert gas is one or more of He, Kr, Ne, Ar and Xe.

Preferably, U₂ is introduced in the capacitively coupled plasma cleaning with a gas flow of 1sccm to 200sccm.

Preferably, the capacitively coupled plasma cleaning has a radio-frequency power of 500W to 2000W, a chamber pressure of 10mT to 50mT and a total gas flow of 100sccm to 500sccm.

Preferably, inert gas is introduced in the inductively coupled plasma cleaning with a gas flow of 50sccm to 300sccm.

Preferably, the inductively coupled plasma cleaning has a radio-frequency power of 500W to 2000W, a chamber pressure of 10mT to 50mT and a total gas flow of 100sccm to 500sccm.

Preferably, an electrode parallel to the window is set in the plasma etching chamber, a Faraday shielding device and a radio-frequency coil are set outside the window.

The present disclosure provides applications of the cleaning method described above for cleaning mixed metal-SiO contamination in a plasma etching chamber.

Preferably, the metal-SiO contamination is attached to the window and wall of the chamber.

Preferably, the metal is one or more of Ru, Ta, TiN, Cu, Ag, Al, Pt and Mg.

The present disclosure provides a method for cleaning plasma etching chambers, comprising following steps: A) Placing cleaning sheet in a plasma etching chamber after the sample processing is completed and introducing inert gas to conduct capacitively coupled plasma cleaning; B) Thereafter, introducing chemical cleaning gas to conduct inductively coupled plasma cleaning; The chemical cleaning gas is one or more of CH2F2, CF4, NF3, SF6 and O₂. In the present disclosure, CCP Faraday physical cleaning is first conducted in the plasma etching chamber, then the ICP chemical cleaning is conducted, this disclosure not only has excellent cleaning effect for both of the mixed metal-SiO contamination attached to wall and window of the chamber, but also improves the cleaning ability for multiple metal contaminations through different combinations of gases.

### BRIEF DESCRIPTION OF DRAWINGS

In order to explain the embodiments of the examples of the present disclosure or the prior art, the drawing needed to be used in the examples or the prior art will be briefly introduced below. Obviously, the drawing in the following description only relates to some of the embodiments of the present disclosure. For those of ordinary skill in the art, other drawings can also be obtained based on the provided drawing without exerting creative efforts according to the provided drawing.

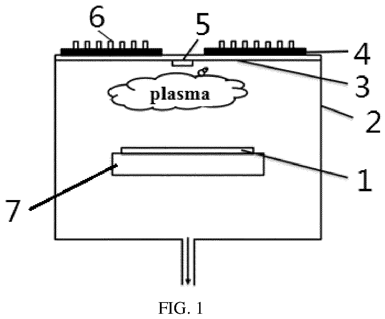

Figure 1 is the structural schematic diagram of the plasma etching chamber in examples of the present disclosure;
1 is the cleaning sheet, 2 is the chamber wall, 3 is the chamber window, 4 is the Faraday shielding device, 5 is the air inlet, 6 is the radio-frequency coil, 7 is the electrode.

### DETAILED DESCRIPTION

The present disclosure provides a method for cleaning plasma etching chambers, comprising following steps:
A) placing a cleaning sheet in a plasma etching chamber after completion of sample processing, and introducing an inert gas for capacitively coupled plasma cleaning; and
B) then introducing a chemical cleaning gas for inductively coupled plasma cleaning;
   wherein the chemical cleaning gas comprises one or more of CH₂F₂, CF₄, NF3, SF₆ and O₂.

In the present disclosure, the plasma etching chamber has the structure shown in Figure 1, wherein an electrode is set in the plasma etching chamber, the electrode is parallel to the window and Faraday shielding device outside the window, a radio-frequency coil is also set outside the window for inductive coupling to generate plasma. A gas inlet is also set on the window.

The plasma etching chamber is also equipped with two radio-frequency matchers. One is used for loading radio-frequency power to Faraday layer (Faraday shielding device), and the other is used for loading radio-frequency power to inner-outer coils (radio-frequency coil). Both of the radio-frequency matchers are controlled by a radio-frequency power supply. An electrode is set in the plasma etching chamber, and the electrode is parallel to the window and Faraday shielding device. When conducting Faraday physical cleaning (capacitively coupled plasma cleaning), the radio-frequency power supply is linked to the Faraday radio-frequency matcher and the coil matcher is not powered, all the power generated by the Faraday matcher is loaded onto the Faraday layer, and the cleaning gas is ionized by capacity coupling in the upper part of the chamber to generate active plasma for capacitively coupled plasma cleaning to the lower surface of the coupling window. When conducting ICP chemical cleaning, the radio-frequency power supply is linked to an inner-outer coil matcher and the Faraday matcher is not powered. The coil generates active plasma via inductive coupling to clean the chamber wall.

In the present disclosure, after the sample processing is completed in the plasma etching chamber, there is a mixed metal-SiO contamination in the chamber, wherein the metal contamination can be Ru, Ta, TiN, Cu, Ag, etc; and the metal-SiO contamination is distributed on both chamber wall and lower surface of the window.

In the present disclosure, the cleaning sheet is first delivered into the chamber, then the inert gas is introduced and the radio-frequency power supply is linked to the Faraday radio-frequency matcher to electrify the Faraday layer for capacitively coupled plasma cleaning.

In the present disclosure, the cleaning sheet adopts bare silicon wafer coated with SiO, which is placed on the surface of the electrode to protect ESC and prevent the rinsed substance from contaminating the surface of ESC.

In the present disclosure, the inert gas is preferably one or more of He, Kr, Ne, Ar and Xe. Preferably, a certain proportion of O₂ is introduced when the inert gas is introduced, which can further improve the cleaning effect. The gas flow of O₂ is preferably 1sccm to 200sccm, more preferably 50sccm to 150sccm, and most preferably 80sccm to 120sccm.

The radio-frequency power of capacitively coupled plasma cleaning is preferably 500W to 2000W, more preferably 1000w to 1500W, such as 500W, 600W, 700W, 800W, 900W, 1000W, 1100W, 1200W, 1300W, 1400W, 1500W, 1600W, 1700W, 1800W, 1900W and 2000W, preferably a range with any of the above values as the upper or lower limit.

Preferably, the chamber pressure is 10mT to 50mT, more preferably 20mT to 40mT, such as 10mT, 15mT, 20mT, 25mT, 30mT, 35mT and 40mT, preferably a range with any of the above values as the upper or lower limit.

The total gas flow is preferably 100sccm to 500sccm, more preferably 200sccm to 400sccm, such as 100sccm, 150sccm, 200sccm, 250sccm, 300sccm, 350sccm, 400sccm, 450sccm and 500sccm, preferably a range with any of the above values as the upper or lower limit.

The time of capacitively coupled plasma cleaning is preferably 2min to 5min, more preferably 3min to 4min, such as 2min, 3min, 4min and 5min, preferably a range with any of the above values as the upper or lower limit. In the present disclosure, cleaning time is related to the etching time. The longer etching time and the greater etching amount, the more contamination produced, which requires an extension of the corresponding cleaning time.

In the present disclosure, the chemical cleaning gas is introduced in the etching chamber after the capacitively coupled plasma cleaning. Then the radio-frequency power supply is linked to inner-outer coils matcher while the Faraday matcher is not powered and conduct inductively coupled plasma cleaning.

In the present disclosure, the chemical cleaning gas comprise one or more of CH₂F₂, CF₄, NF₃, SF₆ and O₂. Preferably, a certain proportion of inert gas can be introduced when conducting inductively coupled plasma cleaning, and the flow of inert gas is preferably 50sccm to 300sccm, more preferably 100sccm to 250sccm, most preferably 150sccm to 200sccm. When ICP chemical cleaning is conducted, inert gas is first introduced to start, then the chemical cleaning gas is introduced.

The radio-frequency power of inductively coupled plasma cleaning is preferably 500W to 2000W, more preferably 1000w to 1500W, such as 500W, 600W, 700W, 800W, 900W, 1000W, 1100W, 1200W, 1300W, 1400W, 1500W, 1600W, 1700W, 1800W, 1900W and 2000W, preferably a range with any of the above values as the upper or lower limit.

The chamber pressure is preferably 10mT to 50mT, more preferably 20mT to 40mT, such as 10mT, 15mT, 20mT, 25mT, 30mT, 35mT and 40mT, preferably a range with any of the above values as the upper or lower limit.

The total gas flow is preferably 100sccm to 500sccm, more preferably 200sccm to 400sccm, such as 100sccm, 150sccm, 200sccm, 250sccm, 300sccm, 350sccm, 400sccm, 450sccm and 500sccm, preferably a range with any of the above values as the upper or lower limit.

The time of inductively coupled plasma cleaning is preferably 2min to 5min, more preferably 3min to 4min, such as 2min, 3min, 4min and 5min, preferably a range with any of the above values as the upper or lower limit. In the present disclosure, cleaning time is related to the etching time. The longer etching time and the greater etching amount, the more contamination produced, which requires an extension of the corresponding cleaning time.

The present disclosure provides a method for cleaning plasma etching chambers, comprising following steps: A) placing a cleaning sheet in a plasma etching chamber after completion of sample processing, and introducing an inert gas for capacitively coupled plasma cleaning; and B) then introducing a chemical cleaning gas for inductively coupled plasma cleaning; wherein the chemical cleaning gas comprises one or more of CH₂F₂, CF₄, NF₃, SF₆ and O₂. In the present disclosure, CCP Faraday physical cleaning is first conducted in the plasma etching chamber, then the ICP chemical cleaning is conducted, which not only has excellent cleaning effect for both the wall and window of the plasma etching chamber, but also improves the cleaning ability for multiple metal contaminations through different combinations of gases.

In order to further describe the present disclosure, the cleaning method for plasma etching chamber and application thereof provided by the present disclosure will be described in detail in combination with examples, but the examples cannot be understood as a limitation to the scope of protection of the present disclosure.

All of the following examples correspond to mixed contamination generated by about 50nm etching amount of Metal (TiN, Ta, Mg, Ru and Cu, etc.) and about 50nm etching amount of SiO.

### Example 1

There was a mixed metal-SiO contamination in the etching chamber after the sample processing was completed;
the cleaning sheet was delivered into the chamber;
a gas combination of Kr (20%), Ar (70%) and O₂ (10%) was introduced and discharged for a start (CCP mode);
after the start was completed, the power was increased to 2000W, and the chamber pressure was controlled to 20mT;
washing was performed for 3 minutes;
a gas combination of NF₃ (80%) and He (20%) was introduced and discharged for a start (ICP mode);
after the start was completed, the power was increased to 2000W, the chamber pressure was controlled to 40mT;
washing was performed for 3 minutes; and
particle data was collected: the amounts of 0.07µm and 0.12µm particles were both about 20 and the cleaning effect was good.

### Example 2

There was a mixed metal-SiO contamination in the etching chamber after the sample processing was completed;
the cleaning sheet was delivered into the chamber;
a gas combination of Xe (20%) and Ar (80%) was introduced and discharged for a start (CCP mode);
after the start was completed, the power was increased to 2000W, and the chamber pressure was controlled to 20mT;
washing was performed for 3 minutes;
a gas combination of SF6 (70%), O₂ (20%) and He (10%) was introduced and discharged for a start (ICP mode);
after the start was completed, the power was increased to 2000W, and the chamber pressure was controlled to 40mT;
washing was performed for 3 minutes;
particle data was collected: the amounts of 0.07µm and 0.12µm particles were both about 20 and the cleaning effect was good.

### Comparative Example 1

There was a mixed metal-SiO contamination in the etching chamber after the sample processing was completed;
the cleaning sheet was delivered into the chamber;
a gas combination of Xe (20%) and Ar (80%) was introduced and discharged for a start (CCP mode);
the power was increased and the chamber pressure was adjusted;
washing was performed for 3 minutes;
the CCP process in comparative example 1 was the same as the CCP process in example 2.
particle data was collected: the amounts of 0.07µm and 0.12µm particles were both above 100 and the cleaning effect was bad.

### Comparative Example 2

There was a mixed metal-SiO contamination in the etching chamber after the sample processing was completed;
the cleaning sheet was delivered into the chamber;
a gas combination of SF6 (70%), O₂ (20%) and He (10%) was introduced and discharged for a start (ICP mode);
the power was increased and the chamber pressure was adjusted;
washing was performed for 3 minutes;
the ICP process in comparative example 2 was the same as the ICP process in example 2.
particle data was collected: the amounts of 0.07µm and 0.12µm particles were both between 40 to 50 and the cleaning effect was general.

### Comparative Example 3

There was a mixed metal-SiO contamination in the etching chamber after the sample processing was completed;
the cleaning sheet was delivered into the chamber;
a gas combination of Kr (20%), Ar (70%) and O₂ (10%) was introduced and discharged for a start (CCP mode);
the power was increased and the chamber pressure was adjusted;
washing was performed for 3 minutes;
the CCP process in Comparative Example 3 was the same as the CCP process in Example 1.

Particle data was collected: the amounts of 0.07µm and 0.12µm particles were both above 100 and the cleaning effect was bad.

### Comparative Example 4

There was a mixed metal-SiO contamination in the etching chamber after the sample processing was completed;
the cleaning sheet was delivered into the chamber;
a gas combination of NF₃ (80%) and He (20%) was introduced and discharged for a start (ICP mode);
the power was increased and the chamber pressure was adjusted;
washing was performed for 3 minutes;
the ICP process in Comparative Example 4 was the same as the ICP process in Example 1.

Particle data was collected: the amounts of 0.07µm and 0.12µm particles were both about 50 and the cleaning effect was general.

The above are only preferred embodiments of the present disclosure. It should be noted that those skilled in the art can make several improvements and modifications without departing from the principles of the present disclosure. These improvements and modifications can also be regarded as falling within the protection scope of the present disclosure.

## Claims

1. A method for cleaning a plasma etching chamber, comprising following steps:
A) placing a cleaning sheet in a plasma etching chamber after completion of sample processing, and introducing an inert gas for capacitively coupled plasma cleaning; and
B) then introducing a chemical cleaning gas for inductively coupled plasma cleaning;
wherein the chemical cleaning gas comprises one or more of CH₂F₂, BCl₃, CF₄, NF₃, SF₆, Cl₂ and O₂.

2. The cleaning method according to claim 1, wherein the inert gas comprises one or more of He, Kr, Ne, Ar and Xe.

3. The cleaning method according to claim 1, wherein O₂ is further introduced during the capacitively coupled plasma cleaning at 1sccm to 200sccm.

4. The cleaning method according to claim 1, wherein the capacitively coupled plasma cleaning has a radio-frequency power of 500W to 2000W, a chamber pressure of 10mT to 50mT and a total gas flow of 100sccm to 500sccm.

5. The cleaning method according to claim 1, wherein an inert gas is further introduced during the inductively coupled plasma cleaning at 50sccm to 300sccm.

6. The cleaning method according to claim 5, wherein the inductively coupled plasma cleaning has a radio-frequency power of 500W to 2000W, a chamber pressure of 10mT to 50mT and a total gas flow of 100sccm to 500sccm.

7. The cleaning method according to claim 1, wherein an electrode parallel to a window is set in the plasma etching chamber, and a Faraday shielding device and a radio-frequency coil are set outside the window.

8. Use of the cleaning method according to claim 1 in cleaning a mixed metal-SiO contamination in a plasma etching chamber.

9. The use according to claim 8, wherein the mixed metal-SiO contamination is at a window and a wall of the chamber.

10. The use according to claim 8, wherein the metal is one or more of Ru, Ta, TiN, Cu, Ag, Al, Pt and Mg.
